# EUROPEAN PATENT SPECIFICATION

(11) **EP 0 606 928 B1**
(45) Date of publication and mention of the grant of the patent: **23.10.1996**
(21) Application number: 94104421.6
(22) Date of filing: 30.01.1992
(51) Int. Cl.: B23Q 3/00, H05K 3/00

(54) **Workpiece clamping means**
Werkstückspannvorrichtung
Moyens d'abloquage d'une pièce

(30) Priority: 11.02.1991 GB 9102850
(43) Date of publication of application: 20.07.1994
(62) Divisional of application: 92300807.2
(73) Proprietor: DEK PRINTING MACHINES LIMITED, Weymouth, Dorset DT4 9TH (GB)
(72) Inventor: Beale, Stephen James, Weymouth, Dorset DT3 5EP (GB)
(74) Representative: Purvis, William Michael Cameron

(56) References cited:
- DD-A- 226 227
- DD-A- 226 228
- DE-U- 9 012 791

## Description

The invention relates to workpiece clamping means.

It is frequently necessary to locate and support a workpiece in a determined position and orientation so that an operation can be effected thereon, particularly an operation which applies pressure to the workpiece, which pressure must be absorbed and resisted by the workpiece support means without causing damage to the workpiece. It may well be necessary to support the workpiece at several locations to prevent it distorting under the force applied to it by the operation.

The invention has particular although not exclusive application to clamping means for printed circuit boards to form electronic circuits during a printing operation thereon, which circuit boards may already include, on a face thereof opposite to the face which is to be printed, circuit components which project from the face of the board.

It is desirable to provide means to secure a board in position against upward movement. Vacuum suction has been proposed, see for example DE-U-90 12 791, but is unsatisfactory particularly when the underside of the board to which vacuum means must be applied is not smooth, for example it may have components thereon, or if the board includes through holes such as those intended to receive wires to connect components.

According to the invention there is provided workpiece clamping means to clamp a workpiece on a conveyor while a screen printing operation is effected on a face of the workpiece, the clamping means comprising a pair of plates located at opposite sides of the workpiece, thin foils projecting laterally from the plates to overlie edge portions of said face of the workpiece and operating means to raise and lower the pair of plates selectively to cause the thin foils to apply a clamping force to the workpiece.

Thus a screen through which printing is effected can overlie the plates during the printing operation without the screen being damaged by a squeegee pressing it against the plates and the workpiece.

Preferably the thin foils have angled end portions and are secured by adhesive to the pair of plates which are raised and lowered by the operating means.

Advantageously the operating means comprise downwardly acting air pistons to effect clamping and spring return means.

The invention is diagrammatically illustrated by way of example in the accompanying drawings in which:-
Figure 1 is a partly sectioned perspective view of workpiece clamping means according to the invention;
Figure 2 is a view taken on arrow II of Figure 1;
Figure 3 is a greatly enlarged view of the portion indicated by the circle III of Figure 2;
Figure 4 is a partly sectioned view teen in the direction of arrow IV of Figure 1;
Figure 5 shows a plan view of a clamping plate of the clamping means of Figures 1 to 4; and
Figure 6 is an end view corresponding to Figure 5.

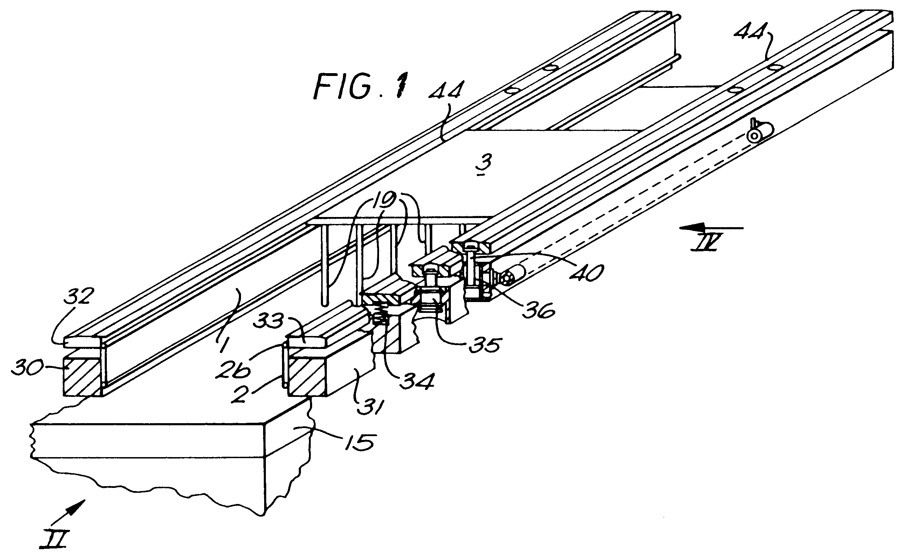

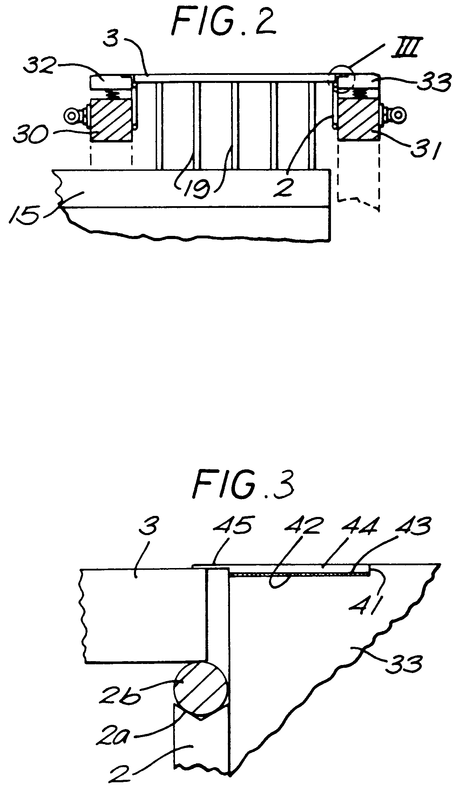

Referring to the drawings, workpiece clamping means are provided to clamp a printed circuit board 3 during screen printing of the upper face thereof. The printed circuit board 3 is provided on the spaced conveyor members 1 and 2 and, as can be seen in Figure 3, the spaced conveyor member 2 comprises a fixed strip with a V-shaped groove 2a in its upper surface in which a conveyor band 2b moves longitudinally to convey the printed circuit board to a printing position and, after printing, from the printing position. Figures 1, 2 and 4 show that the printed circuit board 3 when at the printing position is supported by the upper ends of a plurality of elongate members projecting from a support 15.

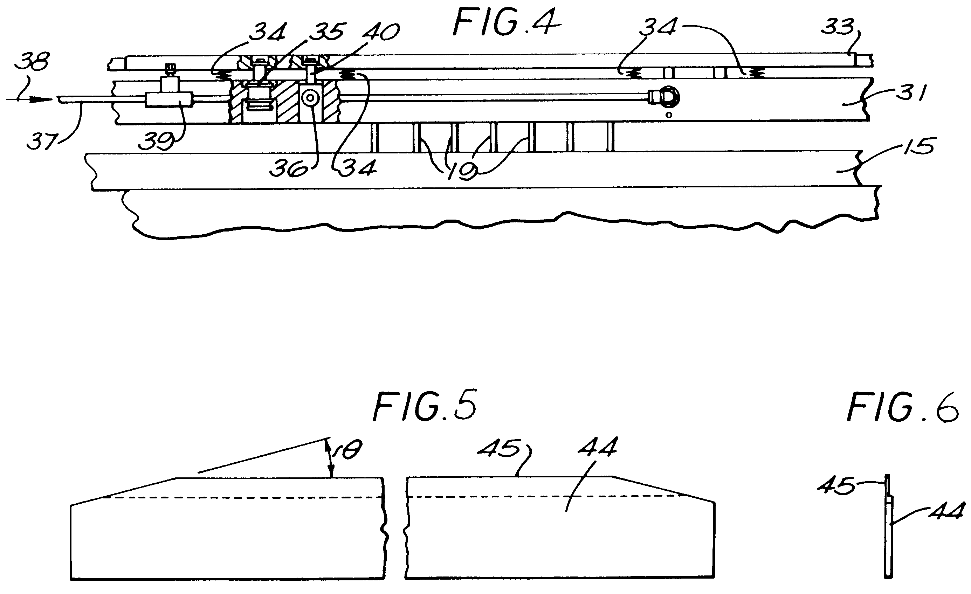

The spaced conveyor members 1 and 2 are mounted on support strips 30 and 31 and respective upper strips 32 and 33 are mounted above the strips 30 and 31. At each end of each of the upper strips 32, 33, connecting means are provided to the respective underlying support strip 30, 31. Referring to Figure 1 and considering the strips 31 and 33 it can be seen at the near end that the strips 31, 33 are coupled together by a compression coil spring 34, a linear bearing 35 and a piston and cylinder arrangement 36. The compression spring 34 biasses the upper strip 33 upwardly away from the support strip 31, the linear bearing 35 restrains upward and downward movement of the strip 33 with respect to the strip 31 to vertical movement and the piston cylinder arrangement 36 is supplied with compressed air through a pipe 37 as indicated by arrow 38 in Figure 4 via a flow regulator 39. The piston cylinder arrangement 36 comprises a piston rod 40 secured at its upper end to the upper strip 33 and having a piston at its lower end engaged in a cylinder in the support strip 31, a port in the cylinder wall through which compressed air is supplied being provided above the piston thereby providing a single acting piston which can apply a downward force to move the upper strip 33 towards the strip 31 in opposition to the force of the compression coil springs 34.

As can be seen in Figure 3, the upper face of the upper strip 33 is rebated at its inner edge to form a recess with a vertical face 41 and a horizontal face 42. Secured within the recess by adhesive 43 is a clamping plate 44 which is cantilevered out from the upper strip 33 and has a recess in its underside at its inner edge so to form an integral foil 45. Thus the foil 45 is provided at the edge of the upper strip 33 which is closest to the opposing upper strip 32 which has a respective clamping plate 44 with clamping foil 45 thereon. The clamping foils 45 overlie the edges of the printed circuit board 3 and apply a downward force thereto.

The clamping plate 44 with the clamping foil 45 is shown in Figures 5 and 6 and it can be seen that inner corners are cut away at an angle φ of for example 15 degrees. The plate 44 may for example be 500mm in length, 0.5mm in thickness and have an overall width of 10mm, the foil 45 representing 2mm of that width and the foil 45 having a thickness of 0.1mm. The angled corner portions extend for 10mm of the length of the strip at each end.

It will be seen therefore that the step provided between the upper face of the clamping plate 44 and the upper face of the printed circuit board 3 being printed is only 0.1mm high and thus the printing screen will not be damaged by extending over the step and having the squeegee passed thereover under pressure. The printed circuit board can however be reliably retained in position during the printing operation.

## Claims

1. Workpiece clamping means to clamp a workpiece (3) on a conveyor (1, 2) while a screen printing operation is effected on a face of the workpiece (3), the clamping means comprising a pair of plates (32, 33) located at opposite sides of the workpiece (3), thin foils (45) projecting laterally from the plates (32, 33) to overlie edge portions of said face of the workpiece (3) and operating means (34, 35, 36) to raise and lower the pair of plates (32, 33) selectively to cause the thin foils (45) to apply a clamping force to the workpiece (3).

2. Workpiece clamping means according to claim 1, in which the thin foils (45) have angled end portions and are secured by adhesive (43) to the portion of plates (32, 33) which are raised and lowered by the operating means (34, 35, 36).

3. Workpiece clamping means according to claim 2, in which the operating means comprise downwardly acting air pistons (36) to effect clamping and spring return means (34).

## Patentansprüche

1. Werkstückspannvorrichtung zum Spannen eines Werkstückes (3) auf eine Beförderungseinrichtung (1, 2) während ein Siebdruckverfahren auf einer Fläche des Werkstückes (3) durchgeführt wird, wobei die Spannvorrichtung ein an gegenüberliegenden Seiten des Werkstückes (3) angeordnetes Plattenpaar (32, 33), dünne von den Platten (32, 33) seitlich hervorragende Folien (45), die Kantenabschnitte der Fläche des Werkstückes (3) überlagern, und Betriebseinrichtungen (34, 35, 36) zum selektiven Anheben und Absenken des Plattenpaares (32, 33), die die dünnen Folien (45) dazu bringen, eine Spannkraft auf das Werkstück (3) auszuüben, umfaßt.

2. Werkstückspannvorrichtung nach Anspruch 1, bei welchem die dünnen Folien (45) abgewinkelte Endabschnitte haben und durch Klebstoff (43) an dem Abschnitt der Platten (32, 33) befestigt sind, welche durch die Betriebseinrichtungen (34, 35, 36) angehoben und abgesenkt werden.

3. Werkstückspannvorrichtung nach Anspruch 2, bei welchem die Betriebseinrichtungen nach unten wirkende Luftdruckkolben (36) zum Bewirken des Spannens und Federrückholeinrichtungen (34) umfassen.

## Revendications

1. Dispositif de serrage de pièce pour serrer une pièce (3) sur un transporteur (1, 2) tandis qu'une opération de sérigraphie est réalisée sur une face de la pièce (3), le dispositif de serrage comprenant une paire de bandes (32, 33) situées sur les côtés opposés de la pièce (3), de minces lames (45) se projetant latéralement depuis les bandes (32, 33) pour recouvrir les portions de bord de ladite face de la pièce (3) et des moyens d'actionnement (34, 35, 36) pour lever et baisser la paire de bandes (32, 33) sélectivement afin d'amener les minces lames (45) à appliquer une force de serrage sur la pièce (3).

2. Dispositif de serrage de pièce selon la revendication 1, dans lequel les minces lames (45) comportent des portions d'extrémité angulaires et sont fixées par un adhésif (43) aux portions des bandes (32, 33) qui sont levées et baissées par les moyens d'actionnement (34, 35, 36).

3. Dispositif de serrage de pièce selon la revendication 2, dans lequel les moyens d'actionnement comprennent des pistons à air agissant vers le bas (36) pour réaliser un serrage et un moyen de rappel à ressort (34).
